(19)

**Europäisches Patentamt**
**European Patent Office**
**Office européen des brevets**

(11) **EP 3 182 413 B1**

(12) **EUROPEAN PATENT SPECIFICATION**

(45) Date of publication and mention
of the grant of the patent:
**29.08.2018 Bulletin 2018/35**

(51) Int Cl.:
**G10L 21/0264** *(2013.01)*    **G10L 21/0232** *(2013.01)*
**G10L 21/0208** *(2013.01)*

(21) Application number: **15200548.4**

(22) Date of filing: **16.12.2015**

(54) **ADAPTIVE LINE ENHANCER BASED METHOD**

ADAPTIVES LEITUNGSVERSTÄRKERBASIERTES VERFAHREN

PROCÉDÉ BASÉ SUR UN AMPLIFICATEUR DE LIGNE ADAPTATIF

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**21.06.2017 Bulletin 2017/25**

(73) Proprietor: **Ruhr-Universität Bochum**
**44801 Bochum (DE)**

(72) Inventors:
• **Martin, Rainer**
**44803 Bochum (DE)**
• **Taghia, Jalal**
**44801 Bochum (DE)**

(74) Representative: **Griepenstroh, Jörg**
**Bockermann Ksoll**
**Griepenstroh Osterhoff**
**Patentanwälte**
**Bergstrasse 159**
**44791 Bochum (DE)**

(56) References cited:
• **ISAO NAKANISHI ET AL: "Speech Enhancement Based on Frequency Domain ALE with Adaptive De-Correlation Parameters", INTERNATIONAL JOURNAL OF COMPUTER THEORY AND ENGINEERING, 1 January 2013 (2013-01-01), pages 292-297, XP055275235, ISSN: 1793-8201, DOI: 10.7763/IJCTE.2013.V5.696**
• **NAOTO SASAOKA ET AL: "Speech enhancement based on adaptive filter with variable step size for wideband and periodic noise", CIRCUITS AND SYSTEMS, 2009. MWSCAS '09. 52ND IEEE INTERNATIONAL MIDWEST SYMPOSIUM ON, IEEE, PISCATAWAY, NJ, USA, 2 August 2009 (2009-08-02), pages 648-652, XP031528075, ISBN: 978-1-4244-4479-3**
• **TAGHIA JALAL ET AL: "A negentropy based adaptive line enhancer for single-channel noise reduction at low SNR conditions", 2014 IEEE INTERNATIONAL CONFERENCE ON ACOUSTICS, SPEECH AND SIGNAL PROCESSING (ICASSP), IEEE, 4 May 2014 (2014-05-04), pages 7073-7077, XP032617684, DOI: 10.1109/ICASSP.2014.6854972 [retrieved on 2014-07-11]**

**Description**

The invention concerns a computer-implemented method for separating random components from periodic components of a given noisy input signal by using an adaptive line enhancer (ALE) filter according to claim 1.

Adaptive line enhancer (ALE) based methods (e.g., [18], [14], [17], [13], [22]) have been developed recently for single-channel speech enhancement. ALE [6] is an adaptive filtering system which can separate the periodic (deterministic) components from the random (stochastic) components in a given signal by using adaptive self-tuning filters. Unlike the traditional single-channel noise reduction algorithms which modify the spectral envelope using a real-valued spectral gain, the ALE modifies the magnitude and phase. Thus, it bears the promise to also improve the intelligibility of the signal. In contrast to an adaptive noise canceller with multiple sensors, ALE uses only a single input signal and generates a delayed version of the input signal to be used in the adaptive filter. The time delay enables the de-correlation of the random components in the delayed signal from those in the input signal, while the periodic components in both the input and the delayed signals will remain correlated. Then, an adaptive filter is applied to the delayed signal in order to extract the periodic components from the input signal by using an adaptive algorithm which exploits the error between the input and the filtered signals. The normalized least-mean-square (NLMS) algorithm (references [7], [8]) is often used for this purpose.

E.g. in [1], the authors proposed a time-domain speech enhancement system which uses an ALE to estimate both wideband and periodic noise in noisy speech. The de-correlation parameter of the ALE is heuristically optimized to differentiate among components of periodic noise, wideband noise and speech. To improve the ability of noise reduction and the speech quality, the background noise estimated by the ALE system is then used to adjust a variable step-size for an NLMS-based noise estimation filter. The variable step-size is a function of the difference between cross-correlations of an enhanced speech signal with noisy speech and the enhanced speech signal with the estimated background noise. Their approach requires knowledge on the pitch (fundamental frequency) of speech for setting the value of the de-correlation parameter.

An ALE can also be implemented in the frequency-domain. In general, frequency-domain adaptive filters have less computational complexity due to the employment of the fast Fourier transform (FFT) for implementing the convolution and filter adaptation (reference [9]). Moreover, adaptive filters in the ALE can be derived separately for each frequency bin as subband signals can be approximately orthogonal.

In reference [2], a frequency-domain ALE (FDALE) has been proposed for single-channel speech enhancement. The adaptive algorithm in this approach is applied to the magnitude spectrum of noisy speech in each frequency band, and the enhanced speech is obtained in the time domain by reusing the phase spectrum of the noisy speech. The step-size of the LMS-based adaptive filter is normalized by the power spectrum of the input signal. The main idea of this work is that the de-correlation parameter of the ALE at each frequency bin is adjusted independently based the signal-to-noise ratio (SNR) and the pitch of the speech signal. However, the task of accurately estimating the pitch and the SNR in adverse environments is challenging, and it may decrease the efficiency of the approach. Moreover, the performance of the approach was validated only for a speech signal degraded by a random white Gaussian noise.

Reference [10] discloses a joint model for stochastic and deterministic components of speech to derive a minimum mean-square error (MMSE) estimator for clean speech. The method employs a sinusoidal model for the reconstruction of deterministic speech components but does not consider the estimation and subtraction of deterministic noise components. In reference [5] an ALE system in the time domain was proposed for splitting the stochastic and deterministic components of noisy speech to reduce the harmonic noise from an observed noisy speech signal. Harmonic noise refers to deterministic and predictable components present in real-life noises such as traffic noise involving horn sounds, the sound of a vacuum cleaner, vehicle engine noise, or noise from kitchen appliances. In [22], the de-correlation parameter of the time-domain ALE as well as the step-size in the adaptive algorithm are fixed. Hence, depending on the type of noise, the suitable step-size is to be determined heuristically.

The problem of the claimed invention to be solved is to provide an improved computer-implemented method for separating random components from periodic components of a given noisy signal by using an adaptive line enhancer.

The invention as claimed concerns a computer-implemented method for separating random components from periodic components of a given noisy input signal x(n) by using an adaptive line enhancer (ALE) filter implemented in the short-time frequency-domain comprising following steps:

 a. transforming the noisy input signal x(n) into the short-time frequency-domain to produce a succession of short time magnitude and phase spectra;

 b. delaying the succession of short-time magnitude and phase spectra of the noisy input signal x(n) are separately to reduce the statistical dependency of random components with respect to the succession of magnitude and phase spectra of the noisy input signal x(n) while leaving the periodic noise components of the input signal x(n) correlated;

c. computing frequency-dependent mutual information measures $I^A(h)$, $I^P(k)$ to quantify the dependency between the magnitudes of the noisy input signal and the magnitudes of the delayed noisy input signal, and the dependency between the phases of the noisy input signal and the phases of the delayed noisy input signal;

d. deriving a frequency-dependent step size $\mu(k)$ using the mutual information measures;

e. controlling an adaptive filter of the adaptive line enhancer (ALE) in the frequency-domain using a set of adaptive weights w(k,m) which are adjusted using the frequency-dependent step-size;

The invention is based on a frequency-domain ALE (FDALE) algorithm for harmonic noise reduction with a novel step-size control based on mutual information (MI). In a preferred embodiment the NLMS algorithm is employed with a fixed de-correlation parameter to derive the adaptive filter in the frequency domain. Preferrable the adaptive algorithm operates on the complex-valued DFT coefficients of noisy speech. Introducing a frequency-dependent step-size to the FDALE algorithm can improve the performance for harmonic noise reduction which conventionally uses a fixed (frequency-constant) step-size. To take the benefit of using a time-varying step-size for the NLMS algorithm in the case of non-stationary input signals, it is preferred to implement the proposed FDALE approach in a block-wise manner such that a new set of values for the frequency-dependent step-size is derived in each of the successive blocks of the input signal.

The main contribution is to exploit the temporal dependence of harmonic noise components in the log-magnitude and phase spectra of noisy speech, and to derive a frequency-dependent step-size which accounts for the presence of harmonic noise in different frequency bins. One measures the temporal dependence by using correlation and mutual information [4]. It is shown that the estimated MI performs better than the correlation coefficient when measuring the predictable structure of harmonic noise components in the noisy speech spectrum.

The effectiveness of the proposed FDALE approach is evaluated for the task of harmonic noise reduction by considering different types of harmonic noise in our experiments. The experimental results confirm that the proposed approach outperforms the conventional FDALE system for reducing harmonic noise and enhancing the speech in terms of instrumental quality and intelligibility measures.

Additional features and advantages of the computer-implemented method will become apparent to those skilled in the art upon consideration of the following detailed description of the illustrated embodiments exemplifying the claimed method. The drawings are given as non-limiting examples.

Let $s(n)$ denote a clean speech signal which is degraded by an additive background noise $v(n)$. Then, the noisy speech $x(n)$ is given by $x(n) = s(n) + v(n)$. It is assumed that $s(n)$ and $v(n)$ are statistically independent.

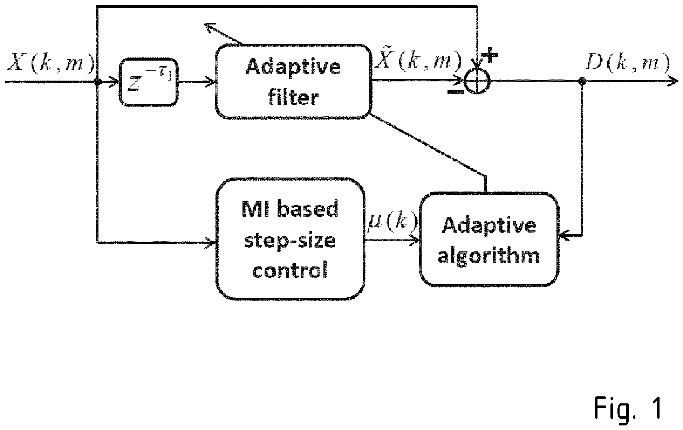

Fig. 1 presents the structure of our proposed FDALE system. Before the adaptive processing, one uses the short-time Fourier transform to transform the noisy input signal $x(n)$ to the frequency domain. The noisy DFT coefficients are denoted by $X(k,m)$ where $k$ and $m$ indicate the frequency bin index and the short-time-frame index, respectively. In our FDALE approach, the error DFT coefficient $D(k,m)$ at each frequency bin $k$ is given by

$$\begin{aligned} D(k,m) &= X(k,m) - \widetilde{X}(k,m) \\ &= X(k,m) - \mathbf{w}^{\mathrm{H}}(k,m)\mathbf{x}(k,m), \end{aligned} \qquad (1)$$

where

$$\mathbf{x}(k,m) = \left[ X(k,m-\tau_1),\ldots,X(k,m-\tau_1-L+1) \right]^{\mathrm{T}} \qquad (2)$$

is a vector of noisy DFT coefficients, $\tau_1$ the de-correlation parameter, and $L$ is the number of coefficients. The superscripts H and T respectively indicate the conjugate (Hermitian) transpose and the transpose operator. In (1), the adjustable weight vector $\mathbf{w}(k,m)$ is defined as $\mathbf{w}(k,m)=[w_0(k,m),...,w_{L-1}(k,m)]^{\mathrm{T}}$, where the filter length is equal to $L$, and the filtered DFT coefficient $\widetilde{X}(k,m)$ is obtained as the inner product $\widetilde{X}(k,m)=\mathbf{w}^H(k,m)\mathbf{x}(k,m)$.

As shown in Fig. 1, the error DFT coefficient $D(k,m)$ is the output of the proposed FDALE system. By applying the proposed FDALE system to the noisy DFT coefficients $X(k,m)$, one subtracts the magnitude and phase spectra of harmonic noise components from the complex spectrum of noisy speech, and consequently the enhanced speech (complex) spectrum is obtained in $D(k,m)$. This is why the proposed FDALE approach performs a phase-correct noise subtraction rather than a noise suppression which would modify the magnitude spectrum of noisy speech by using a real-valued spectral gain.

The preferred algorithm in the FDALE is based on the NLMS method which attempts to minimize the MSE cost function

$$J = \mathbb{E}\left\{|\, D(k,m)\,|^2\right\}$$

by employing the stochastic gradient descent.

The following weight update recursion is used which incorporates a distinct step-size parameter $\mu(k)$ at each frequency bin $k$

$$\mathbf{w}(k,m+1) = \mathbf{w}(k,m) + \frac{\mu(k)D^*(k,m)\mathbf{x}(k,m)}{\varepsilon_0 + \left\|\mathbf{x}(k,m)\right\|^2}, \qquad (3)$$

where * denotes the conjugate operator and $\|\bullet\|$ stands for the $L_2$-norm. $\varepsilon_0$ is a small constant which excludes the possible division by zero.

The proposed FDALE system (shown in Fig. 1) is preferrably performed in a block-wise processing scheme: The time-domain input signal is first segmented into several overlapping blocks where the block length $N$ is chosen 3s and the overlap is 25%. Then, filter weights are initialized to zero for each block, and the adaptive filter weights are derived by applying the proposed FDALE system to the input signal in each block, separately. Finally, the output signals of the FDALE system are windowed by a Tukey (flat-top) window, and subsequently are concatenated via the overlap-add procedure to produce the full-length signal in the output. In this embodiment, the block length $N$ = 3 s is long enough for robust computation of MI. By using the block-wise processing, one has the opportunity of adjusting completely new filter weights for the FDALE system every 3 s. Furthermore, it is to note that block-adaptive filtering generally can provide the possibility of efficient implementation using parallel processors.

Mutual information $I(U;V)$ between two real-valued random variables $U$ and $V$ is defined (reference [4]) as

$$I(U;V) = \mathbb{E}_{U,V}\left\{\log\left(\frac{p_{U,V}}{p_U p_V}\right)\right\}, \qquad (4)$$

where $\mathbb{E}_{\bullet}\{\cdot\}$ denotes the expectation operator over the distribution of the random variables in the subscript. Based on the differential entropy, the definition of MI in (4) can be rewritten as

$$I(U;V) = h(U) + h(V) - h(U,V), \qquad (5)$$

where

$$h(U) = -\mathbb{E}_U\{\log(p_U)\}$$

and

$$h(V) = -\mathbb{E}_V\{\log(p_V)\}$$

denote the marginal differential entropies, and

$$h(U,V) = -\mathbb{E}_{U,V}\left\{\log\left(p_{U,V}\right)\right\}$$

denotes the joint differential entropy. One can also express the definition of MI $I(U;V)$ in (5) in terms of the conditional differential entropy

$$h(U|V) = -\mathbb{E}_{U,V}\left\{\log\left(p_{U|V}\right)\right\}$$

as

$$I(U;V) = h(U) - h(U|V). \qquad (6)$$

In the following, by applying the relation between the mutual information and the minimum mean square error (MMSE), it is to explore the difference between the MI and the correlation in measuring the mutual dependence of random variables.

Let $U$ denote a real-valued random variable. It can be shown (reference [16]) that the MMSE estimate of $U$ is its mean value

$$\mathbb{E}_U\{U\}$$

and the MMSE is equal to the variance $\sigma_U^2$ of the random variable i.e.,

$$mmse(U) = \mathbb{E}_U\{(U - \mathbb{E}_U\{U\})^2\} = \sigma_U^2. \qquad (7)$$

The *estimation error and differential entropy* theorem [4, Theorem 8.6.6, Page 255] states

$$h(U) \leq \frac{1}{2}\log(2\pi e\,mmse(U)) = \frac{1}{2}\log(2\pi e\sigma_U^2), \qquad (8)$$

where $h(U)$ stands for the differential entropy of $U$, and the equality in (8) holds only if $U$ has a Gaussian distribution. In other words, a Gaussian (normally) distributed random variable has the maximum entropy over all distributions which have the same first and second moments [4].

When there is additional information from another real-valued random variable $V$, then the MMSE estimate of $U$ is denoted by

$$\hat{u}(V) = \mathbb{E}_{U|V}\{U|V\}$$

and the MMSE is expressed as

$$mmse(U|V) = \mathbb{E}_{U,V}\left\{\left(U - \hat{u}(V)\right)^2\right\}. \qquad (9)$$

Since the joint probability density function (PDF) of the random variables is usually unknown, in practice an approximation is made by considering the MMSE estimate $\hat{u}(V)$ to be an affine function of the observed random variable $V$. Then, the MMSE estimator is approximated by a linear minimum mean square error (LMMSE) [16] as

$$lmmse(U|V) = \sigma_U^2(1 - \rho_{u,v}^2). \qquad (10)$$

where $\rho_{u,v}$ is the correlation coefficient defined as

$$\rho_{u,v} = \frac{\mathbb{E}_{U,V}\{U,V\} - \mathbb{E}_U\{U\}\mathbb{E}_V\{V\}}{\sigma_U\sigma_V}, \qquad (11)$$

where $\sigma_U$ and $\sigma_V$ denote the standard deviations of $U$ and $V$.

Moreover, it is notable that LMMSE is a suboptimal solution for non-Gaussian random variables, i.e.,

$$\mathrm{mmse}\left(U\middle|V\right) \le \mathrm{lmmse}\left(U\middle|V\right) = \sigma_U^2 (1 - \rho_{u,v}^2). \tag{12}$$

In the special case that two random variables $U$ and $V$ have a bivariate Gaussian PDF, it can be shown [16] that the equality holds in (12).

An interesting corollary of the *estimation error and differential entropy* theorem [4, Theorem 8.6.6, Page 255] relates the conditional entropy $h(U|V)$ to the MMSE as

$$h(U\middle|V) \le \frac{1}{2}\log\left(2\pi e\, \mathrm{mmse}\left(U\middle|V\right)\right). \tag{13}$$

Hence, by applying (12) in (13), we have

$$h(U\middle|V) \le \frac{1}{2}\log\left(2\pi e\, \mathrm{lmmse}\left(U\middle|V\right)\right), \tag{14}$$

where the equality in (13) and (14) is achieved if and only if $U$ and $V$ have a bivariate Gaussian probability distribution. In other words, random variables which follow a bivariate Gaussian probability distribution have the maximum conditional differential entropy over all distributions which have the same first and second moments [4].

Importantly, the statement in (14) may be used to derive a lower bound $I_{LB}(U;V)$ on the mutual information $I(U;V)$ by applying (14) to (6), i.e.,

$$I_{\mathrm{LB}}(U,V) = h(U) - \frac{1}{2}\log\left(2\pi e\, \mathrm{lmmse}\left(U\middle|V\right)\right). \tag{15}$$

This lower bound is achieved only if $U$ and $V$ have a bivariate Gaussian probability distribution.

If one approximates the joint PDF of the arbitrary random variables $U$ and $V$ by a bivariate Gaussian PDF, then the mutual information $I_g(U,V)$ can be obtained as an estimate of the true mutual information $I(U;V)$ in (6), i.e.,

$$\begin{aligned}
I_{\mathrm{g}}(U,V) &= h(U_{\mathrm{g}}) - \frac{1}{2}\log\left(2\pi e\, \mathrm{lmmse}\left(U\middle|V\right)\right) \\
&= \frac{1}{2}\log\left(2\pi e\sigma_U^2\right) - \frac{1}{2}\log\left(2\pi e\sigma_U^2\left(1 - \rho_{u,v}^2\right)\right) \\
&= -\frac{1}{2}\log\left(1 - \rho_{u,v}^2\right),
\end{aligned} \tag{16}$$

where

$$U_g \sim \mathcal{N}\left(\mathbb{E}_U(U), \sigma_U^2\right)$$

is a Gaussian distributed random variable with the same mean and variance as the arbitrary random variable $U$. According to reference [3], $I_g(U,V)$ is regarded as an information-theoretic measure of the overall correlation between two real-valued random variables $U$ and $V$. Particularly, $I_g(U,V) \ge 0$ with equality only if $U$ and $V$ are uncorrelated (but not necessarily independent).

By comparing two expressions (15) and (16), one can notice that the term $\frac{1}{2}\log\left(2\pi e\, \mathrm{lmmse}\left(U\middle|V\right)\right)$ is common in both $I_{LB}(U,V)$ and $I_g(U,V)$. Thus, by taking the fact into account that a Gaussian random variable has the largest differential entropy, we have

$$I_{\mathrm{LB}}(U,V) \leq I_{\mathrm{g}}(U,V), \tag{17}$$

with equality only if $U$ and $V$ follow a bivariate Gaussian PDF.

Moreover, the mutual information $I(U;V) = h(U)-h(U|V)$ between two random variables $U$ and $V$ with arbitrary distributions can be either less/greater than or equal to $I_{\mathrm{g}}(U,V)$ because Gaussian random variables have the largest conditional differential entropy (as indicated in (14)) besides having the largest marginal differential entropy (defined in (8)), i.e.,

$$I(U;V) \underset{>}{\overset{<}{=}} I_{\mathrm{g}}(U,V), \tag{18}$$

with equality only if the joint PDF of the random variables $U$ and $V$ is Gaussian. In other words, $I_g(U,V)$ is a lower bound on the true mutual information $I(U;V)$ if the error in estimating the conditional differential entropy $h(U|V)$ using the LMMSE estimator is larger than the error introduced by approximating the marginal differential entropy $h(U)$ with the differential entropy $h(U_g)$ of the Gaussian random variable $U_g$. Thus, there is no simple general relation between MI and the Gaussian approximation in terms of the correlation coefficient.

The following section reviews mutual information (MI) for complex-valued data. Let $X$ and $Y$ denote two arbitrary complex-valued random variables which are represented in the polar coordinate system as

$$\begin{aligned} X &= X_{\|} e^{jX_{\angle}}, \\ Y &= Y_{\|} e^{jY_{\angle}}, \end{aligned} \tag{19}$$

where $X_{\|}$, $Y_{\|} \in [0,\infty]$ denote the magnitudes (or amplitudes), and $X_{\angle}$, $Y_{\angle} \in [\pi,-\pi]$ denote the phases of the random variables $X$ and $Y$, respectively.

The polar decomposition of mutual information has been recently addressed in reference [6]. Based on the chain rule [4, Theorem 2.5.2, Page 24], it was shown in [6] that MI $I(X;Y)$ can be decomposed into four terms as

$$\begin{aligned} I(X;Y) &= I\big((X_{\|}, X_{\angle});(Y_{\|},Y_{\angle})\big) \\ &= I\big(X_{\|};(Y_{\|},Y_{\angle})\big) + I\big(X_{\angle};(Y_{\|},Y_{\angle})\big|X_{\|}\big) \\ &= I\big(X_{\|};Y_{\|}\big) + I\big(X_{\angle};Y_{\angle}\big|X_{\|}\big) \\ &\quad + I\big(X_{\|};Y_{\angle}\big|Y_{\|}\big) + I\big(X_{\angle};Y_{\|}\big|(X_{\|},Y_{\angle})\big), \end{aligned} \tag{20}$$

where the first two terms of the last expression are called the amplitude term and the phase term respectively, and the next two terms are called the mixed terms.

By assuming that the phase and magnitude of the complex-valued random variables $X$ and $Y$ are statistically independent, it has been shown [27] that the mixed terms $I(X_{\|};Y_{\angle}|Y_{\|})$ and $I(X_{\angle};Y_{\|}|X_{\|},Y_{\angle})$ are negligibly small compared to the magnitude and phase terms. Then, the polar decomposition of MI between $X$ and $Y$ can be expressed as

$$I(X;Y) \approx I\big(X_{\|};Y_{\|}\big) + I\big(X_{\angle};Y_{\angle}\big|X_{\|}\big) \tag{21}$$

The term $I(X_{\angle};Y_{\angle}|X_{\|})$ is given as

$$I\big(X_{\angle};Y_{\angle}\big|X_{\|}\big) = h\big(X_{\angle}\big|X_{\|}\big) - h\big(X_{\angle}\big|Y_{\angle},X_{\|}\big), \tag{22}$$

where due to the independence assumption of the magnitude and phase of the random variables, we rewrite (22) as

$$I\left(X_{\angle};Y_{\angle}\big|X_{\parallel}\right) \approx h\left(X_{\angle}\right) - h\left(X_{\angle}\big|Y_{\angle}\right)$$
$$= I\left(X_{\angle};Y_{\angle}\right). \tag{23}$$

Finally, by applying (23) in (21), the total mutual information between two arbitrary complex random variables $X$ and $Y$ in (20) is simplified as

$$I(X;Y) \approx I\left(X_{\parallel};Y_{\parallel}\right) + I\left(X_{\angle};Y_{\angle}\right). \tag{24}$$

The polar decomposition of MI in (24) is the primary motivation for looking at the magnitude and the phase spectra separately when we measure the temporal dependence of the noisy spectrum at each frequency bin in this approach.

The MI can be estimated by both non-parametric and parametric approaches. Non-parametric estimation approaches [1] are statistical methods which do not assume that the data is from a known distribution. On the other hand, for parametric approaches, the data is supposed to be from a known family of distributions. The parameters of probability density functions are optimized by fitting the model to the data.

The k-nearest neighbor (KNN) estimator (references [10], [5]) and the histogram-based estimator are non-parametric approaches which are used here for MI estimation. The KNN approach estimates the marginal and joint entropies of two random variables based on the metric properties of nearest neighbor balls in both the marginal and joint spaces. The kth nearest neighbor parameter determines the volume and the probability measure of the nearest neighbor balls. Later on, the MI value estimated by the KNN approach is denoted with $I_{\mathrm{KNN}}$.

The MI can also be estimated by using the histogram density estimator (references [1], [7]). An empirical rule for selecting the binwidth of the histogram based estimator needs to be adopted to reduce the bias in the MI estimation. We use the criterion which is introduced in [19, Theorem 3.5] for choosing the binwidth of the histogram based approach to estimate the marginal and joint entropies. The MI value estimated by the histogram based approach is denoted by $I_{\mathrm{hist}}$.

Moreover, a parametric approach based on the Gaussian mixture model (GMM) for the MI estimation is used. In a simple embodiment the invention exploits statistical learning of model parameters via the expectation-maximization (EM) algorithm [2]. In a more refined embodiment, the variational Bayes (VB) approach [2, Chapter 10] may be used to form the GMM. The variational Bayes method, unlike the maximum-likelihood EM approach, does not suffer from singularities (i.e., when one of the Gaussian components collapses on a specific data point) and over-fitting problems. It can automatically determine the optimal number of mixture components. The MI is computed in (4) by replacing the true probability distributions with the GMM estimates. The MI value estimated by the VB-based GMM approach is denoted by $I_{\mathrm{VB}}$.

As mentioned before, the correlation coefficient can be used in (16) to obtain the overall correlation $I_g$ which is regarded as an information-theoretic criterion. $I_g$ is used for measuring the mutual dependence and approximating the MI since it relies on the Gaussian assumption for the marginal and joint probability distributions of random variables. The values of estimated MI i.e., $I_{\mathrm{KNN}}$, $I_{\mathrm{hist}}$, $I_{\mathrm{VB}}$, and the values of overall correlation $I_g$ are computed in nats.

In the following, initial experimental results are provided to show the temporal dependence in the magnitude and phase spectra of a clean speech signal as well as a noisy signal.

In this experiment, a clean speech signal is degraded by vacuum cleaner noise (taken from Sound Ideas database [15]) at 5 dB SNR. The clean speech has a total duration of 7 minutes taken from the TIMIT database [28] and includes fourteen male and fourteen female speakers. For the transformation of signals sampled at 16 kHz to the frequency domain, a DFT-based spectral analysis-synthesis system with overlapping square-root Hann windows is used. The window length as well as the DFT length are 512 samples (32 ms) and the frame shift is 128 samples providing a temporal resolution of 8 ms.

To measure the temporal dependence, at first the magnitude and phase spectra of noisy speech are separately delayed by two short-time frames (i.e., 16 ms). Then, the mutual dependence between the original spectrum and its delayed version is measured at each frequency bin for the magnitude and phase spectra individually.

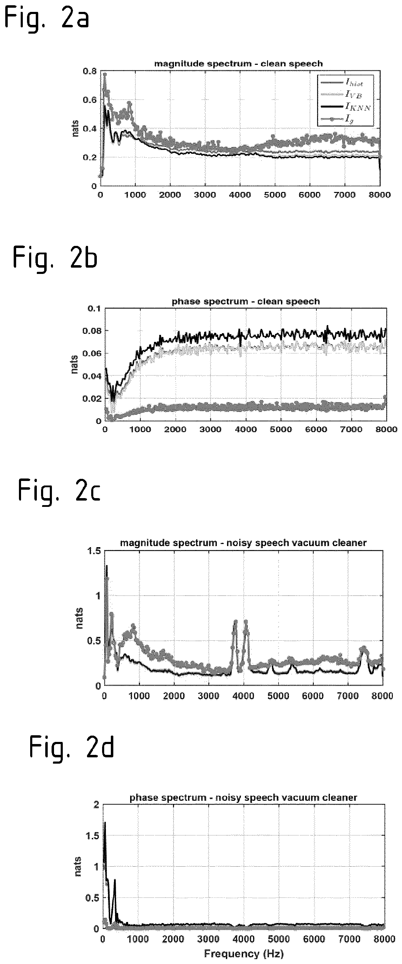

Fig. 2 shows the estimated MI values $I_{\mathrm{KNN}}$, $I_{\mathrm{hist}}$, $I_{\mathrm{VB}}$ and the overall correlation $I_g$ for the magnitude and phase spectra of the clean speech signal and the noisy speech. In the case of the clean speech in Fig. 2-(a,b), it can be observed that the mutual dependence for the magnitude spectrum is much larger than that of the phase spectrum. Moreover, the mutual dependence for the magnitude spectrum in the low frequency bins (e.g., below 1 kHz) is larger than that in high frequency bins.

The pattern of the mutual dependence for both the magnitude and phase spectra of the noisy speech in Fig. 2-(c,d) is different from the pattern obtained for the clean speech. The appearance of peaks in these patterns are related to the periodic temporal structure of harmonic noise components.

Although in the case of the magnitude spectrum (see Fig. 2-(c)) the overall correlation $I_g$ as well as the estimated MI values (i.e., $I_{KNN}$, $I_{hist}$, $I_{VB}$) are able to detect the temporal dependence related to the harmonic noise, the overall correlation $I_g$ cannot provide a clear detection of the mutual dependence for the phase spectrum as shown in Fig. 2-(d).

From the results in Fig. 2, it can observed that the estimated MI values $I_{KNN}$, $I_{hist}$, $I_{VB}$ are close to each other while the overall correlation $I_g$ is different from the estimated MI. In the case of magnitude spectrum for both the clean speech and the noisy speech, it can be observed higher values of $I_g$ than those of the estimated MI. In the case of the phase spectrum, it can be observed that the overall correlation $I_g$ underestimates the MI. This observation follows the general expression (18) which we derived earlier to show the relation between the overall correlation and the mutual information.

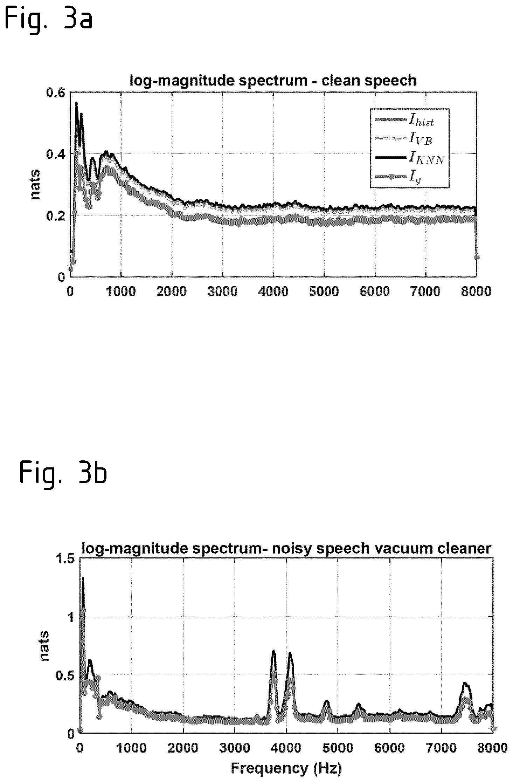

The magnitude spectra of the clean and the noisy DFT coefficients have a single-sided probability distribution while according to the expression (18), the overall correlation $I_g$ is equal to the MI if the Gaussian assumption for the underlying distributions of the random variables is valid. Hence, to better fulfill the Gaussian assumption, the log-magnitude spectrum instead of the magnitude spectrum is investigated. In Fig. 3, the MI values $I_{KNN}$, $I_{hist}$, $I_{VB}$ and the overall correlation $I_g$ for the log-magnitude spectra of the clean speech signal and the noisy speech are shown. Due to this modification, it can be observed in Fig. 3-(a,b) that the overall correlation has a better match with the estimated MI in comparison to the results in Fig. 2-(a,c).

The following section describes the procedure for driving a frequency-dependent step-size control of the FDALE system. The temporal dependence in the log-magnitude and phase spectra of noisy speech to adjust the step-size $\mu(k)$ depending on the predictable structure of harmonic noise is exploited. The idea is to increase the step-size in frequency bins which are dominated by the periodic components of harmonic noise. This task is performed by the MI-based step-size control block shown in Fig. 1.

From the results in Fig. 2 and Fig. 3, it can be observed that for large datasets the estimation approaches of MI (i.e., the KNN approach, the histogram based method, and the VB based GMM approach) provide considerably a similar performance. However, among these estimation methods, the KNN approach to estimate MI ($I_{KNN}$) is selected since it can provide a sufficiently accurate estimation of mutual information also for short-length data [10], and in comparison to the VB-based GMM approach it has a lower computational cost.

In addition to the KNN method ($I_{KNN}$), the overall correlation $I_g$ for measuring the mutual dependence is used. Although the overall correlation $I_g$ does not necessarily provide an estimate of MI (as shown in Section 3.1 and equation (18)), it has the advantage of having a very low computational cost due to relying only on the computation of the correlation coefficient according to (16).

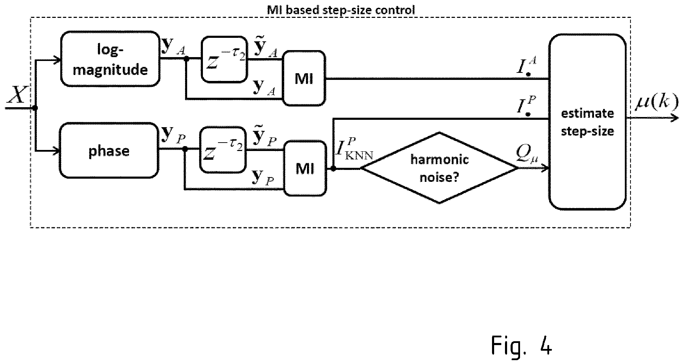

The block diagram in Fig. 4 illustrates the proposed algorithm for estimating the step-size $\mu(k)$ Let $\mathbf{y}_A(k)=[\log(|X(k,1)|),...,\log(|X(k,M)|)]^T$ and $\mathbf{y}_P(k)=[\angle X(k,1),...,\angle X(k,M)]^T$ respectively denote the vectors of the log-magnitude and phase of noisy speech DFT coefficients at frequency bin $k$, and $M$ indicate the number of short-time frames. Furthermore, the delayed versions of the vectors $y_A(k)$ and $y_P(k)$ are denoted by $\tilde{y}_A(k)$ and $\tilde{y}_P(k)$ and defined as

$$\tilde{y}_A(k) = \left[\mathbf{0}_{\tau_2}, \log(|X(k,1)|),...,\log(|X(k,M-\tau_2)|)\right]^T,$$
$$\tilde{y}_P(k) = \left[\mathbf{0}_{\tau_2}, \angle X(k,1),..., \angle X(k,M-\tau_2)\right]^T, \tag{25}$$

where $\tau_2$ denotes the time-delay in terms of short-time frames.

We define $I_\bullet^A(k)$ as the value of mutual dependence for the log-magnitude spectrum,

$$I_\bullet^A(k) = I(y_A(k), \tilde{y}_A(k)), \tag{26}$$

where the subscript $\bullet$ indicates the estimation approach for computing the mutual dependence. $I_\bullet^A(k)$ is estimated either by the KNN method and denoted with $I_{KNN}^A(k)$ or by the overall correlation and denoted with $I_g^A(k)$. Similarly, we define $I_\bullet^P(k)$ as the value of mutual dependence for the phase spectrum,

$$I_\bullet^P(k) = I\left( y_P(k), \widetilde{y}_P(k) \right),\qquad\qquad (27)$$

where it is also estimated either by the KNN method $I_{\mathrm{KNN}}^P(k)$ or by the overall correlation $I_{\mathrm{g}}^P(k)$.

In the proposed FDALE approach there are two distinct time-delay parameters $\tau_1$ and $\tau_2$. As defined in (2) and shown in Fig. 1, $\tau_1$ is the de-correlation parameter for the ALE system which is fixed for all frequency bins. On the other hand, as defined in (25) and illustrated in Fig. 4, the delay parameter $\tau_2$ provides a time-delay in the log-magnitude and phase spectra. Hence, $\tau_2$ affects the temporal dependence that is measured by either mutual information or the overall correlation, and is important for adjusting the step-size $\mu(k)$.

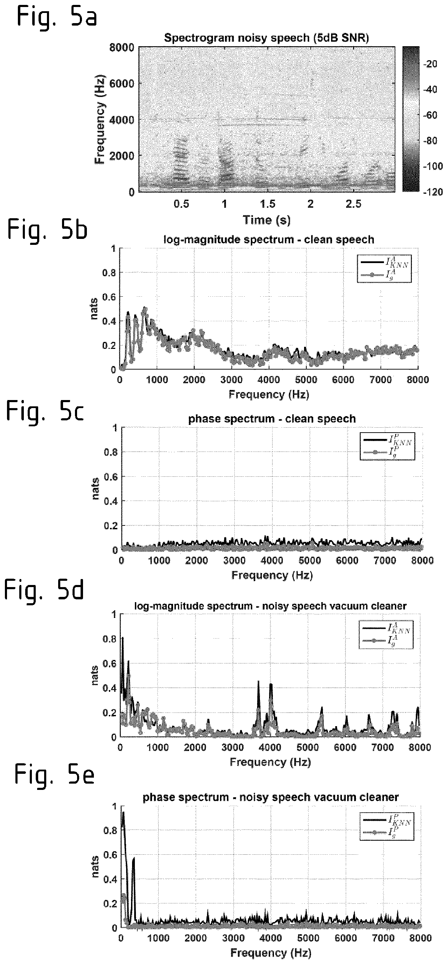

Let's consider an example of how the step-size is estimated in the proposed algorithm. In Fig. 5 a), we show the spectrogram of a 3s-long segment of noisy speech degraded by vacuum cleaner noise at 5dB SNR. Fig. 5 b) presents the values of mutual information estimated by the KNN approach $I_{\mathrm{KNN}}^A(k)$ and the overall correlation $I_{\mathrm{g}}^A(k)$ for the log-magnitude spectrum of clean speech signal and noisy speech. Moreover, Fig. 5 c) d) e) show the values $I_{\mathrm{KNN}}^P(k)$ and $I_{\mathrm{g}}^P(k)$ for the phase spectrum of clean speech signal and of the noisy speech. The same DFT-based spectral analysis-synthesis system as already introduced is used, and the results in Fig. 5 are obtained for the delay parameter $\tau_2 = 2$ (i.e., 16 ms time delay).

Among the different speech components, voiced sounds have a quasi-periodic time structure [25, Chapter 2] while other speech components (e.g., unvoiced sounds) have a spectrum with stochastic nature. Voiced sounds appear as low-pass spectra whereas unvoiced sounds generally have a high-pass spectrum. From Fig. 5-(b) it can be observed that below 1 kHz there is a relatively high amount of mutual dependence in the log-magnitude spectrum of clean speech where the first peak in this band is related to the fundamental frequency. On the other hand, by looking at the phase spectrum of clean speech in Fig. 5-(c), it can be noticed that the amount of mutual dependence is generally small particularly in the frequency band below 1 kHz.

Since it is an object of the invention to detect the periodic structure of harmonic noise but not the speech components, the frequency range is devided into two separate bands, one from 0 to 1 kHz and the other from 1 kHz up to the Nyquist frequency. To adjust the step-size in the low frequency band (i.e., below 1 kHz), we look for the predictable structure of harmonic noise only in the phase spectrum of noisy speech but not in its log-magnitude spectrum. The reason is that the low frequency band of noisy speech besides the noise involves mostly voiced speech and the log-magnitude spectrum of noisy speech in this frequency band is dominated by the predictable structure of speech components. On the other hand, according to pilot experiments, the predictable structure of harmonic noise is evident in the phase spectrum (see Fig. 5-(e)), and hence is used for adjusting the step-size.

In the high frequency band (i.e., above 1 kHz), mainly due to the absence of strong predictable and quasi-periodic components of speech (i.e., voiced sounds) and the presence of unvoiced sounds having a random structure, we consider the log-magnitude spectrum in addition to the phase spectrum to find the predictable structure of harmonic noise in both log-magnitude and phase spectra.

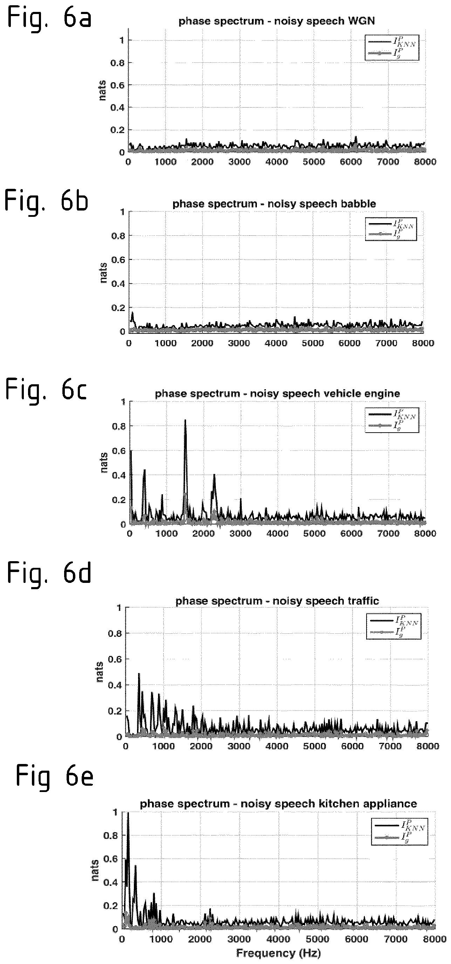

It is made a decision on the type of additive noise based on the MI values obtained for the phase spectrum of noisy speech. Furthermore, Fig. 6 presents the MI values $I_{\mathrm{KNN}}^P(k)$ and $I_{\mathrm{g}}^P(k)$ obtained for the phase spectrum of noisy speech when a 3 s-long segment of clean speech is degraded by different types of additive noise such as traffic noise involving horn sounds (Fig. 6 d)), vehicle engine noise (Fig. 6c)), noise from a kitchen appliance (Fig. 6e)) which similarly to the sound of vacuum cleaner contain harmonic components. For the sake of comparison, Fig. 6 a) also presents the same results for a 3 s-long segment of clean speech corrupted with white Gaussian noise (WGN) and babble noise (Fig. 6b)) having a random structure. All results in this figure are also obtained for the delay parameter $\tau_2 = 2$.

One can observe from the results (presented in Fig. 5 and Fig. 6) that the MI values $I_{\mathrm{KNN}}^P(k)$ estimated by the KNN approach are helpful for differentiating the harmonic noise from either the random noise or the clean speech signal since the values of $I_{\mathrm{KNN}}^P(k)$ for harmonic noises are noticeably greater than those of random noises (e.g., WGN and babble noise) which have unpredictable structure in their spectrum. The values of the overall correlation $I_{\mathrm{g}}^P(k)$

are not useful for the task of determining the noise type robustly.

Therefore, in the decision block of our algorithm (see Fig. 4), the energy of the sequence of estimated MI values $I_{\text{KNN}}^{P}(k)$ over all frequency bins of the phase spectrum of noisy speech is used to determine whether the clean speech is corrupted with harmonic noise, i.e.,

$$Q_{\mu} = \begin{cases} 1 & \text{if } \sum_{k=1}^{K} \left( I_{\text{KNN}}^{P}(k) \right)^{2} \geq I_{thr} \\ 0, & otherwise \end{cases} \qquad (28)$$

where the upper limit $K$ denotes the total number of frequency bins, and $I_{thr}$ is a constant. The coefficient $Q_{\mu}$ in (28) is equal to 1 when the clean speech is corrupted with harmonic noise. Hence, the coefficient $Q_{\mu}$ controls the values of the step-size $\mu(k)$ as

$$\mu(k) = Q_{\mu} \mu_0 \alpha(k), \qquad (29)$$

where $\mu_0$ is a constant, and $\alpha(k)$ is a coefficient that is determined based on the MI values. If the energy of the MI values $I_{\text{KNN}}^{P}(k)$ is larger than the threshold $I_{thr}$, the proposed FDALE system is used to determine the step-size $\mu(k)$ otherwise the step-size $\mu(k)$ is set to zero for all frequency bins meaning that the noisy signal is bypassed to the output. It is noted that alternatively *a priori* information on the noise type also can be used to determine whether the speech signal is corrupted by harmonic noise or not.

Although the smallest value that the estimated MI and the overall correlation can take is zero, they are not upper-bounded. Generally, the upper-bound on mutual information for continuous random variables is infinity. In order to transfer the values of mutual dependence $I_{\bullet}^{P}(k)$ and $I_{\bullet}^{A}(k)$ to a range between 0 and 1, the following normalization is performed,

$$\bar{I}_{\bullet}^{P}(k) = \frac{I_{\bullet}^{P}(k) - \min\left(I_{\bullet}^{P}\right)}{\max\left(I_{\bullet}^{P}\right) - \min\left(I_{\bullet}^{P}\right)}, \qquad (30)$$

where either $I_{\text{KNN}}^{P}(k)$ obtained by the KNN method or $I_{\text{g}}^{P}(k)$ computed by the overall correlation can be used in (30). Similarly, the same normalization as (30) is employed for the values $I_{\bullet}^{A}(k)$ to derive $\bar{I}_{\bullet}^{A}(k)$.

Motivated by the expression (24), which shows the contributions of the magnitude and phase terms in the total MI between two complex-valued random variables, it is defined a total mutual dependence value $\bar{I}_{\bullet}^{total}(k)$ by adding up the contributions of the log-magnitude and phase spectra in the mutual dependence,

$$\bar{I}_{\bullet}^{total}(k) = \bar{I}_{\bullet}^{A}(k) + \bar{I}_{\bullet}^{P}(k), \qquad (31)$$

where according to our earlier discussion in this section, $\bar{I}^{total}(k)$ is used for adjusting the step-size $\mu(k)$ in high frequency band (i.e., frequencies above 1 kHz).

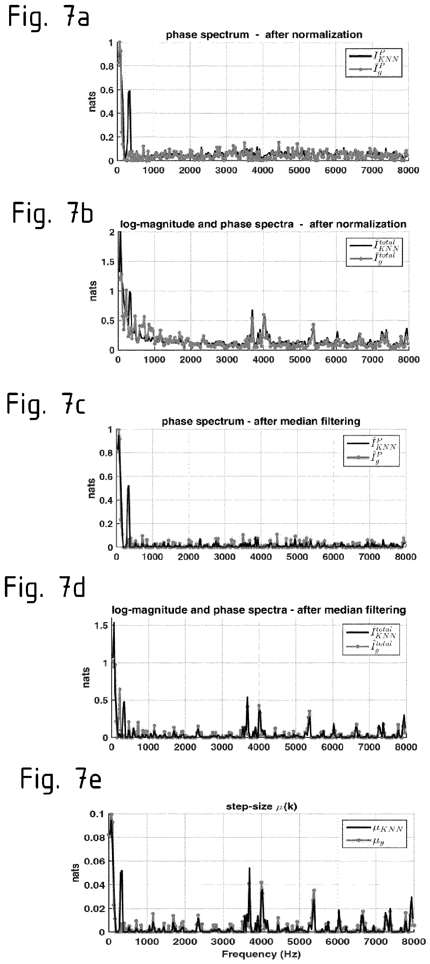

Fig. 7-(a,b) show the normalized values of mutual dependence $\bar{I}_{\bullet}^{P}$ and $\bar{I}_{\bullet}^{total}$ which are obtained by (30) and (31) for a 3 s-long segment of noisy speech when the clean speech is degraded by vacuum cleaner noise at 5 SNR (i.e., the same signal used in Fig. 5). The peaks in the pattern of values $\bar{I}_{\bullet}^{P}(k)$ and $\bar{I}_{\bullet}^{total}(k)$ are important since they show frequency bins in which the harmonic noise components are present. The next step is to extract the peaks and remove the bias from the values $\overline{I}_\bullet^P(k)$ and $\overline{I}_\bullet^{total}(k)$ by applying a median filter as follows,

$$\hat{I}_\bullet^P(k) = \max\left\{\overline{I}_\bullet^P(k) - \text{medianfilt}\left(\overline{I}_\bullet^P(k), n_1\right), 0\right\}, \qquad (32)$$

$$\hat{I}_\bullet^{total}(k) = \max\left\{\overline{I}_\bullet^{total}(k) - \text{medianfilt}\left(\overline{I}_\bullet^{total}(k), n_2\right), 0\right\}, \qquad (33)$$

where medianfilt($\cdot$) stands for a median filter, and the constants $n_1$ and $n_2$ indicate the order of the median filter applied to the values $\overline{I}_\bullet^P$ and $\overline{I}_\bullet^{total}$, respectively. The negative values of $\hat{I}_\bullet^P(k)$ and $\hat{I}_\bullet^{total}(k)$ are set to zero by the maximum operator max$\{\cdot\}$.

The filtered values of mutual dependence $\hat{I}_\bullet^P$ and $\hat{I}_\bullet^{total}$ obtained after applying the median filter are shown in Fig. 7-(c,d). The order of median filters is chosen small enough to preserve the location of peaks in their original pattern. We set $n_1 = 12$ and $n_2 = 16$ for the results presented in Fig. 7-(c,d). By employing the median filter using (32) and (33), the bias is removed from the envelope of the sequence of mutual dependence values $\overline{I}_\bullet^P(k)$ and $\overline{I}_\bullet^{total}(k)$, and the peaks of their fine structure remain in $\hat{I}_\bullet^P(k)$ and $\hat{I}_\bullet^{total}(k)$.

By denoting $k^*$ as the frequency bin for the cut-off frequency, we define the coefficient $\alpha(k)$ at each frequency bin $k$,

$$\alpha(k) = \begin{cases} \hat{I}_\bullet^P(k) & \text{if } k \le k^* \\ \hat{I}_\bullet^{total}(k) & \text{if } k > k^*. \end{cases} \qquad (34)$$

Finally, the coefficient $\alpha(k)$ obtained in (34) is used for computing the step-size $\mu(k)$ of ALE at each frequency bin according to (29). Fig. 7-(e) presents the step-size values $\mu(k)$ for the corresponding 3 s-long noisy speech.

As mentioned before, the proposed FDALE approach presented in Fig. 1 and Fig. 4 is performed in a block-wise manner. For an arbitrarily long noisy input signal, a new set of values of step-size $\mu(k)$ is derived for each of the successive 3 s-long blocks of the signal.

In the following section, the experimental results of our proposed FDALE system are provided. In the proposed FDALE system, for the transformation of signals sampled at 16 kHz into the frequency domain, the same DFT-based spectral analysis-synthesis system was used. The number of tap coefficients $L$ for the adaptive filter in (2) is set to 5 (i.e., the length of filter is 40 ms).

The threshold $I_{thr}$ in the decision block (28) which is used for the detection of harmonic noise is chosen through the pilot experiments for 3 s-long segments of noisy speech when clean speech is degraded by different types of harmonic noises. $I_{thr}$ ist set to $I_{thr} = 1$ nats. The constant parameter $\mu_0$ in (29) is set to 0.1.

The orders of median filter used for deriving the filtered values of mutual dependence $\hat{I}_\bullet^P(k)$ and $\hat{I}_\bullet^{total}(k)$ are respectively set to $n_1 = 12$ and $n_2 = 16$ in (32) and (33). This setting is done based on pilot experiments for gaining a good overall performance for different harmonic noise types used in the experimental results. The cut-off frequency bin $k^*$ in (34) is set to 32 that is equivalent to 1 kHz.

In the proposed FDALE approach, there are two parameters $\tau_1$ and $\tau_2$. As defined in (2), $\tau_1$ is the de-correlation parameter for the ALE system which here is fixed for all frequency bins. Based on the pilot experiments, one can observe that by choosing $\tau_1$ equal to only one short-time frame (i.e., $\tau_1 = 1$) we can achieve the best reduction of noise and preservation of speech intelligibility.

The delay parameter $\tau_2$ provides a delay in the log-magnitude and phase spectra of noisy speech and affects the temporal dependence between the original spectrum and its delayed one. The values of mutual dependence $I_\bullet^P(k)$ and $I_\bullet^A(k)$ are changed by altering the delay parameter $\tau_2$, and hence $\tau_2$ affects the step-size $\mu(k)$. By using $\tau_2$, one can decrease the contribution of the temporal dependence of speech components in $\alpha(k)$ while preserving the contribution of the temporal dependence of harmonic noise components in $\alpha(k)$. Based on the pilot experiments, it was confirmed that $\tau_2 = 2$ is the optimum choice to obtain the best results for speech enhancement.

The clean speech signal has a total duration of 120 s taken from the TIMIT database [28] and includes four male and four female speech signals where each one has a duration of 15 s. The experiments are performed with four different real-life acoustic noises which contain harmonic components such as traffic noise involving horn sounds, the sound of a vacuum cleaner and a kitchen appliance which are taken from Sound Ideas database [15], and additionally a vehicle engine noise taken from Noisex-92 database [24]. The clean speech signal is degraded by each of these noise types at an overall SNR from -5 to 10 dB in 5 dB steps.

The performance of the proposed approach is evaluated with respect to the speech quality enhancement by using the improvement in the segmental SNR [12] ΔSSNR in dB and the improvement in Perceptual Evaluation of Speech Quality measure ΔPESQ as implemented in [12]. Furthermore, the enhancement of speech intelligibility was evaluated by means of two instrumental intelligibility measures, the Short-Time Objective Intelligibility (STOI) measure [21] and the mutual information based intelligibility measure MI-KNN [23]. We use ΔSTOI and ΔMIKNN for denoting the percentage (%) of improvement in the value of STOI and MI-KNN.

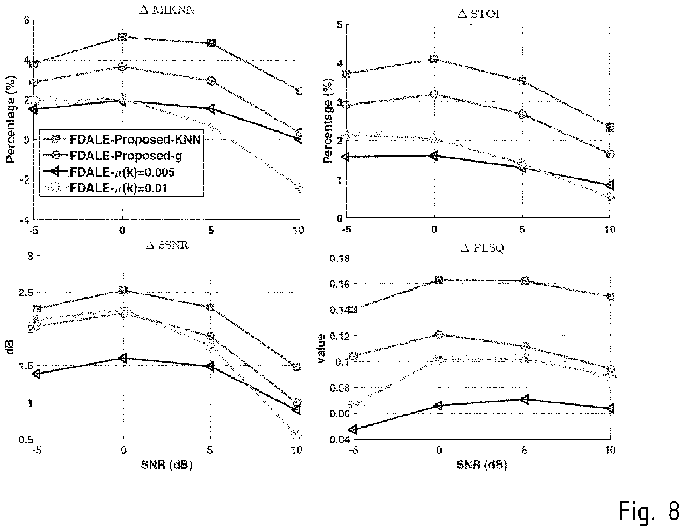

Fig. 8 shows the result averaged over four different noise types. The performance of the proposed FDALE approach is indicated by "FDALE-Proposed-KNN" when the KNN method is used for estimating MI and is indicated by "FDALE-Proposed-g" when the overall correlation is exploited for measuring the mutual dependence. To demonstrate the benefit of the frequency dependent step-size control on the performance of the FDALE system, one can compare the performance of our proposed FDALE approach with an FDALE system which employs a fixed step-size $\mu(k) = \mu_1$ for all frequency bins, indicated by "FDALE-$\mu(k) = \mu_1$". For the demonstration in Fig. 8, two different values $\mu_1$ = {0.005,0.01} are selected which are found heuristically to be the most appropriate values of fixed step-size operation of the algorithm.

As can be observed in Fig. 8, the best performance is obtained using the proposed approach "FDALE-Proposed-KNN" in which the MI estimation is performed by the KNN method.

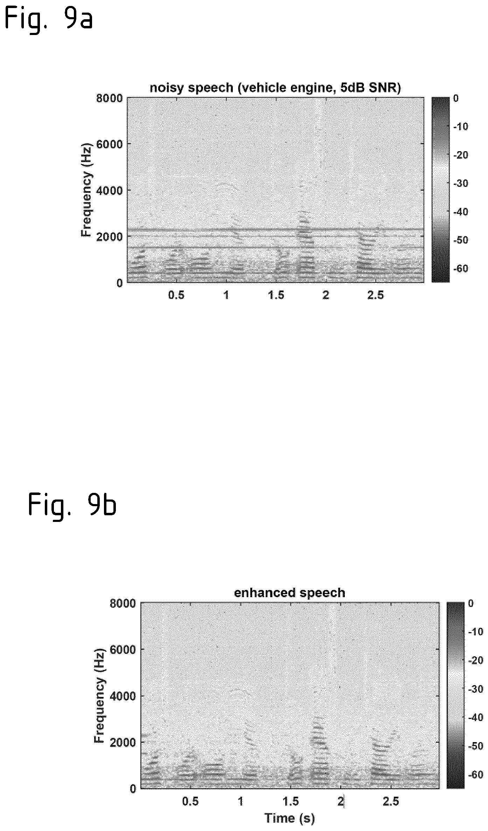

Fig. 9a demonstrates the performance of "FDALE-Proposed-KNN" for a 3 s-long noisy female speech segment degraded by vehicle engine noise at 5 dB SNR. Fig. 9b presents the spectrogram of the noisy speech signal and the spectrogram of the enhanced speech signal using the proposed approach "FDALE-Proposed-KNN". The harmonic noise components are removed without affecting the speech or the random noise components. The results are obtained for the delay parameter $\tau_2 = 2$.

The invention employs a frequency-domain adaptive line enhancer (FDALE) for harmonic noise reduction. In the proposed FDALE approach, the NLMS method benefits from a frequency-dependent step-size which is adjusted based on the temporal structure of harmonic noise components in the log-magnitude and phase spectra of the noisy speech. The step-size increases in the frequency bins which are dominated by the periodic components of harmonic noise and have a large temporal dependence.

To measure the temporal dependence, at first the log-magnitude and phase spectra of noisy speech are separately delayed. Then, the mutual dependence between the original spectrum and its delayed version is measured at each frequency bin for the log-magnitude and phase spectra individually. Mutual information (MI) and correlation are used for measuring the mutual dependence. Speech signals include some predictable components like voiced sounds in the low frequency part of their magnitude spectrum; while in the high frequency part, they mainly have a random structure. On the other hand, the phase spectrum of speech in long-term sense is more random (unpredictable) than its magnitude spectrum particularly in the low frequency band. Hence, in the process of detecting the temporal dependence of harmonic noise components, the whole frequency range is split into two frequency bands. In the low frequency band, only the phase spectrum of noisy speech is accounted for measuring the temporal dependence while in the high frequency band both the log-magnitude and phase spectra of noisy speech are considered. In this way, one can exclude the contribution of the predictable structure of speech when the temporal dependence is measured in the low frequency band.

One can observe from the results shown in Fig. 8 that both versions of the proposed FDALE approach (i.e., "FDALE-Proposed-KNN" and "FDALE-Proposed-g") benefit from the frequency-dependent step-size and can clearly outperform the conventional FDALE system with a fixed step-size ("FDALE-$\mu(k) = \mu_1$") for harmonic noise reduction. In particular, the proposed FDALE has the advantage of preserving speech components, and hence improving the speech intelligibility as indicated by the instrumental intelligibility measures STOI and MI-KNN. Even, at high SNR levels (e.g., 10 dB), the proposed approach "FDALE-Proposed-KNN" is able to provide a considerable gain for both noise reduction and speech preservation.

The results in Fig. 8 show that "FDALE-Proposed-KNN", in which the frequency-dependent step-size is derived by estimating mutual information using the KNN method, performs better than "FDALE-Proposed-g" that exploits the correlation coefficient for computing the overall correlation and adjusting the step-size. Thus, one can conclude that the estimation of mutual information can provide a more accurate measurement of the temporal dependence and a better detection of harmonic noise components than computing the overall correlation using the correlation coefficient. However, the advantage of "FDALE-Proposed-g" over "FDALE-Proposed-KNN" is the low computational cost of calculating the correlation coefficient compared to the estimation of mutual information by using the KNN method.

The proposed FDALE system subtracts the magnitude and phase spectra of noise harmonics from the complex spectrum of noisy speech to achieve a noise subtraction rather than a noise suppression which conventionally modifies the magnitude spectrum of the noisy speech signal using a gain function. As can be observed in Fig. 9, the harmonic components of the vehicle engine noise are removed from the noisy speech spectrum without distorting the speech spectrum. Thus, the proposed FDALE system is capable to also improve the intelligibility of the speech signal as predicted by the instrumental intelligibility measures in our experiments.

As the final point, it is to note that the proposed FDALE may be used as a preprocessor for any other noise reduction system to remove the harmonic noise components in the pre-processing stage. Then, it may be combined, for example, with a conventional Wiener filter to reduce random noise components as well.

The references mentioned in the description are:

[1] J. Beirlant, E. J. Dudewicz, L. Györfi, and E. C. van der Meulen. Nonparametric entropy estimation: An overview. Int. J. Math. Stat. Sci., 6:17-39, 1997.

[2] C. M. Bishop. Pattern recognition and machine learning. Springer, 2006.

[3] J. F. Cardoso. Dependence, correlation and Gaussianity in independent component analysis. The Journal of Machine Learning Research, 4:1177-1203, 2003.

[4] T. M. Cover and J. A. Thomas. Elements of information theory. Wiley, 2006.

[5] D. Evans. A computationally efficient estimator for mutual information. Proc. R. Soc. A, Mathematical, Physical and Engineering Sciences, 464:1203-1215, 2008.

[6] B. Goebel, R. Essiambre, G. Kramer P. J. Winzer, and N. Hanik. Calculation of mutual information for partially coherent Gaussian channels with applications to fiber optics. IEEE Transactions on Information Theory, 57(9):5720-5736, Sept. 2011.

[7] P. Hall and S. C. Morton. On the estimation of the entropy. Ann. Inst. Statist. Math., 45:69-88, 1993.

[8] S. Haykin. Adaptive filter theory. Prentice Hall, 2002.

[9] R. C. Hendriks, R. Heusdens, and J. Jensen. An MMSE estimator for speech enhancement under a combined stochastic-deterministic speech model. IEEE Transactions on Audio, Speech, and Language Processing, pages 406-415, Feb. 2007.

[10] A. Kraskov, H. Stögbauer, and P. Grassberger. Estimating mutual information. Phys. Rev. E 69 (6) 066138, pages 1-16, 2004.

[11] S.M. Kuo and D.R. Morgan. Active noise control systems: algorithms and DSP implementations. 2006.

[12] P. Loizou. Speech Enhancement: Theory and Practice. CRC, Boca Raton, Florida, 2007.

[13] I. Nakanishi, Y. Itoh, and Y. Fukui. Noise reduction system based on frequency domain adaptive filter using modified DFT pair. The 2001 IEEE International Symposium on Circuits and Systems, 2:737-740, May 2001.

[14] I. Nakanishi, H. Namba, and S. Li. Speech enhancement based on frequency domain ALE with adaptive de-correlation parameters. International Journal of Computer Theory and Engineering, 5(2):292-297, 2013.

[15] B. Nimens. Sound Ideas: sound effects collection. Series 6000; http://www.sound-ideas.com/6000.html.

[16] A. V. Oppenheim and G. C. Verghese. Estimation with minimum mean square error. Introduction to Communication, Control, and Signal Processing: Lecture Notes, MIT, 2010.

[17] R. M. Ramli, A. O. Abid Noor, and S. A. Samad. A review of adaptive line enhancers for noise cancellation. Australian Journal of Basic and Applied Sciences, 6(6):337-352, 2012.

[18] N. Sasaoka, K. Shimida, S. Sonobe, Y. Itoh, and K. Fujii. Speech enhancement based on adaptive filter with variable step size for wideband and periodic noise. in Proceedings of IEEE International Midwest Symposium on Circuits and Systems, pages 648-652, Mexico, Cancun, 2009.

[19] D. W. Scott. Multivariate density estimation: theory, practice, and visualization. 1992.

[20] J.J. Shynk. Frequency-domain and multirate adaptive filtering. IEEE Signal Processing Magazine, 9(1):14-37, Jan 1992.

[21] C. H. Taal, R. C. Hendriks, R. Heusdens, and J. Jensen. An algorithm for intelligibility prediction of time-frequency weighted noisy speech. IEEE Transactions on Audio, Speech, and Language Processing, 19(7):2125-2136, September 2011.

[22] J. Taghia and R. Martin. A negentropy based adaptive line enhancer for single-channel noise reduction at low SNR conditions. IEEE International Conference on Acoustics, Speech, and Signal Processing (ICASSP), pages 7073-7077, May 2014.

[23] J. Taghia and R. Martin. Objective intelligibility measures based on mutual information for speech subjected to speech enhancement processing. IEEE Transactions on Audio, Speech, and Language Processing, 22(1):6-16, January 2014.

[24] A. Varga and H. J. M. Steeneken. Assessment for automatic speech recognition: II. Noisex-92: A database and an experiment to study the effect of additive noise on speech recognition systems. Speech Commun., 12(3):247?251, 1993.

[25] P. Vary and R. Martin. Digital Speech Transmission - Enhancement, Coding and Error Concealment. John Wiley, 2006.

[26] B. Widrow, J.R. Glover, J.M. McCool, J. Kaunitz, C.S. Williams, R.H. Hearn, J.R. Zeidler, D. Eugene, Jr., and R.C. Goodlin. Adaptive noise cancelling: Principles and applications. Proceedings of the IEEE, 63(12):1692-1716, Dec 1975.

[27] Q. Xie, Z. Wang, and Z. Yang. Polar decomposition of mutual information over complex-valued channels. eprint arXiv:1304.0260 [Computer Science - Information Theory], March 2013.

[28] TIMIT, acoustic-phonetic continuous speech corpus. DARPA, NIST Speech Disc 1-1.1, Oct. 1990.

**Claims**

1. Computer-implemented method for separating random components from periodic components of a given noisy input signal x(n) by using an adaptive line enhancer (ALE) filter implemented in the short-time frequency-domain comprising following steps:

   a. transforming the noisy input signal x(n) into the short-time frequency-domain to produce a succession of short-time magnitude and phase spectra;
   b. delaying the succession of short-time magnitude and phase spectra of the noisy input signal x(n) separately to reduce the statistical dependency of random components with respect to the succession of magnitude and phase spectra of the noisy input signal x(n) while leaving the periodic noise components of the input signal x(n) correlated;
   c. computing frequency-dependent mutual information measures ($I^A(k)$, $I^P(k)$) to quantify the dependency between the magnitudes of the noisy input signal and the magnitudes of the delayed noisy input signal, and the dependency between the phases of the noisy input signal and the phases of the delayed noisy input signal;
   d. deriving a frequency-dependent step-size ($\mu(k)$) using the mutual information measures;
   e. controlling an adaptive filter of the adaptive line enhancer (ALE) in the frequency-domain using a set of adaptive weights (w(k,m)) which are adjusted using the frequency-dependent step-size.

2. Computer-implemented method according to claim 1, *characterized in that the* transformation of the noisy input signal into the short-time frequency-domain is performed by a filter bank.

3. Computer-implemented method according to claim 1, *characterized in that the* transformation of the noisy input signal into the short-time frequency-domain is performed by a discrete Fourier-transform (DFT).

4. Computer-implemented method according to claim 1, *characterized in that the* transformation of the noisy input signal into the frequency-domain is performed by an orthogonal transform.

5. Computer-implemented method according to one of the preceding claims, *characterized in that* the calculation of the mutual information (MI) is based on complex components or a function of said complex components of the transformed noisy input signal and the delayed transformed noisy input signal.

6. Computer-implemented method according to one of the preceding claims, *characterized in that* in a first step the mutual information (MI) is determined separately based on the real part and the imaginary part of the complex component of the transformed noisy input signal and the delayed transformed input signal and by combining said separately calculated results to a total mutual information using mathematical operators selected from the group consisting of: addiction, multiplication, computation of the mean, computation the geometric mean, computation of an exponential function, computation of a logarithmic function, computation of the median, computation of the maximum, and computation of the minimum.

7. Computer-implemented method according to one of the preceding claims, *characterized in that* the mutual information (MI) is determined by a function of the amplitude and by a function of the phase and by combining said separately calculated results to a total mutual information using mathematical operators selected from the group consisting of: addition, multiplication, computation of the mean, computation the geometric mean, computation of an exponential function, computation of a logarithmic function, computation of the median, computation of the maximum, and computation of the minimum.

8. Computer-implemented method according to one of the preceding claims, *characterized in that* the mutual information (MI) is computed separately based on the logarithm of the amplitudes and based on the phases of the complex spectral components of the noisy input signal and by combining said separately calculated results to a total mutual information using mathematical operators selected from the group consisting of: addition, multiplication, computation of the mean, computation the geometric mean, computation of an exponential function, computation of a logarithmic function, computation of the median, computation of the maximum, and computation of the minimum.

9. Computer-implemented method according to one of the preceding claims, *characterized in that* the mutual information (MI) is determined based on the respective magnitude and phase spectra of the noisy input signal and the delayed noisy input signal and the computation of the mutual information is based on the correlation coefficient and mathematical operators selected from the group consisting of: addition of a constant value, multiplication with a constant value, computation of an exponential function, computation of a logarithmic function, and computation of a trigonometric function.

10. Computer-implemented method according to one of the preceding claims, *characterized in that* the mutual information (MI) is determined by a nearest neighbor algorithm based on the respective magnitude and phase spectra of the noisy input signal and the delayed noisy input signal.

11. Computer-implemented method according to one of the preceding claims, *characterized in that* the mutual information (MI) is determined by a histogram-based estimation based on the respective magnitude and phase spectra of the noisy input signal and the delayed noisy input signal.

12. Computer-implemented method according to one of the preceding claims, *characterized in that* the mutual information (MI) is determined by a parameter-based estimator based on the respective magnitude and phase spectra of the noisy input signal and the delayed noisy input signal using a Gaussian mixture model (GMM) and a maximum-likelihood estimator or a variational Bayesian algorithm for learning the model parameters.

13. Computer-implemented method according to one of the preceding claims, *characterized in that* the mutual information (MI) is derived for the logarithm of the respective amplitudes and for the respective phases of the complex spectral components of the noisy input signal and the at least one delayed noisy input signal, wherein both contributions are weighted and added and the weighting factors for weighted addition are frequency-dependent.

**14.** Computer-implemented method according to one of the preceding claims, *characterized in that* the adaptive filter is implemented as finite impulse response (FIR) filter or infinite impulse response (IIR) filter.

**15.** Computer-implemented method according to one of the claims 1 to 13 *characterized in that* the adaptive filter is implemented as at least one of the following filters: least mean squares (LMS) filter, normalized least mean squares (NLMS) filter, recursive least squares (RLS) filter.

**16.** Computer-implemented method according to one of the preceding claims, *characterized in that* the adaptive filter receives/emits more than one input and/or output signal.

**17.** Computer-implemented method according to one of the preceding claims, *characterized in that* the time-domain input signal is separated into several blocks, wherein the frequency-dependent step-size is calculated only once for each block.

**18.** Computer-implemented method according to one of the preceding claims, *characterized in that* said mutual information and/or said calculated step-size are subject to modification employing a median filter.

**19.** Computer-implemented method according to one of the preceding claims, *characterized by* removing an offset or a trend from the mutual information (MI) before deriving the step-size.

**Patentansprüche**

**1.** Computerimplementiertes Verfahren zum Trennen von zufälligen Komponenten von periodischen Komponenten eines gegebenen rauschbehafteten Eingangssignals x(n) durch Verwenden eines adaptiven Leitungsverbesserer-(ALE) Filters, der in der Kurzzeit-Frequenzdomäne implementiert ist, umfassend folgende Schritte:

a. Transformieren des rauschbehafteten Eingangssignals x(n) in die Kurzzeit-Frequenzdomäne, um eine Abfolge von Kurzzeitgrößen- und Phasenspektren zu erzeugen;
b. getrenntes Verzögern der Abfolge von Kurzzeitgrößen- und Phasenspektren des rauschbehafteten Eingangssignals x(n), um die statistische Abhängigkeit von zufälligen Komponenten im Hinblick auf die Abfolge von Größen- und Phasenspektren des rauschbehafteten Eingangssignals x(n) zu verringern, während die periodischen Rauschkomponenten des Eingangssignals x(n) korreliert hinterlassen werden;
c. Berechnen von frequenzabhängigen wechselseitigen Informationsmaßen ($I^A(k)$, $I^P(k)$), um die Abhängigkeit zwischen den Größen des rauschbehafteten Eingangssignals und den Größen des verzögerten rauschbehafteten Eingangssignals, und die Abhängigkeit zwischen den Phasen des rauschbehafteten Eingangssignals und den Phasen des verzögerten rausch behafteten Eingangssignals zu quantifizieren;
d. Ableiten einer frequenzabhängigen Schrittgröße ($\mu(k)$) unter Verwendung der wechselseitigen Informationsmaße;
e. Steuern eines adaptiven Filters des adaptiven Leitungsverbesserers (ALE) in der Frequenzdomäne unter Verwendung eines Satzes adaptiver Gewichtungen (w(k,m)), die unter Verwendung der frequenzabhängigen Schrittgröße angepasst werden.

**2.** Computerimplementiertes Verfahren nach Anspruch 1, *dadurch gekennzeichnet, dass* die Transformation des rauschbehafteten Eingangssignals in die Kurzzeit-Frequenzdomäne über eine Filterbank durchgeführt wird.

**3.** Computerimplementiertes Verfahren nach Anspruch 1, *dadurch gekennzeichnet, dass* die Transformation des rauschbehafteten Eingangssignals in die Kurzzeit-Frequenzdomäne über eine diskrete Fourier-Transformation (DFT) durchgeführt wird.

**4.** Computerimplementiertes Verfahren nach Anspruch 1, *dadurch gekennzeichnet, dass* die Transformation des rauschbehafteten Eingangssignals in die Frequenzdomäne über eine orthogonale Transformation durchgeführt wird.

**5.** Computerimplementiertes Verfahren nach einem der vorstehenden Ansprüche, *dadurch gekennzeichnet, dass* die Berechnung der wechselseitigen Information (MI) auf komplexen Komponenten oder einer Funktion der komplexen Komponenten des transformierten rauschbehafteten Eingangssignals und des verzögerten transformierten rauschbehafteten Eingangssignals basiert.

**6.** Computerimplementiertes Verfahren nach einem der vorstehenden Ansprüche, *dadurch gekennzeichnet, dass* in einem ersten Schritt die wechselseitige Information (MI) getrennt auf dem realen Teil und dem gedachten Teil der komplexen Komponente des transformierten Eingangssignals und des verzögerten transformierten rauschbehafteten Eingangssignals basierend, und durch Kombinieren der getrennt berechneten Ergebnisse zu einer gesamten wechselseitigen Information unter Verwendung von mathematischen Operatoren bestimmt wird, ausgewählt aus der Gruppe bestehend aus: Addition, Multiplikation, Berechnung des Mittels, Berechnung des geometrischen Mittels, Berechnung einer Exponentialfunktion, Berechnung einer logarithmischen Funktion, Berechnung des Medians, Berechnung des Maximums, und Berechnung des Minimums.

**7.** Computerimplementiertes Verfahren nach einem der vorstehenden Ansprüche, *dadurch gekennzeichnet, dass* die wechselseitige Information (MI) über eine Funktion der Amplitude und über eine Funktion der Phase, und durch Kombinieren der getrennt berechneten Ergebnisse zu einer gesamten wechselseitigen Information unter Verwendung von mathematischen Operatoren bestimmt wird, ausgewählt aus der Gruppe bestehend aus: Addition, Multiplikation, Berechnung des Mittels, Berechnung des geometrischen Mittels, Berechnung einer Exponentialfunktion, Berechnung einer logarithmischen Funktion, Berechnung des Medians, Berechnung des Maximums, und Berechnung des Minimums.

**8.** Computerimplementiertes Verfahren nach einem der vorstehenden Ansprüche, *dadurch gekennzeichnet, dass* die wechselseitige Information (MI) getrennt nach dem Logarithmus der Amplituden und nach den Phasen der komplexen Spektralkomponenten des rauschbehafteten Eingangssignals, und durch Kombinieren der getrennt berechneten Ergebnisse zu einer gesamten wechselseitigen Information unter Verwendung von mathematischen Operatoren berechnet wird, ausgewählt aus der Gruppe bestehend aus: Addition, Multiplikation, Berechnung des Mittels, Berechnung des geometrischen Mittels, Berechnung einer Exponentialfunktion, Berechnung einer logarithmischen Funktion, Berechnung des Medians, Berechnung des Maximums, und Berechnung des Minimums.

**9.** Computerimplementiertes Verfahren nach einem der vorstehenden Ansprüche, *dadurch gekennzeichnet, dass* die wechselseitige Information (MI) basierend auf den jeweiligen Größen- und Phasenspektren des rauschbehafteten Eingangssignals und des verzögerten rauschbehafteten Eingangssignals bestimmt wird, und die Berechnung der wechselseitigen Information auf dem Korrelationskoeffizienten und mathematischen Operatoren basiert, ausgewählt aus der Gruppe bestehend aus: Addition eines konstanten Werts, Multiplikation mit einem konstanten Wert, Berechnung einer Exponentialfunktion, Berechnung einer logarithmischen Funktion, und Berechnung einer trigonometrischen Funktion.

**10.** Computerimplementiertes Verfahren nach einem der vorstehenden Ansprüche, *dadurch gekennzeichnet, dass* die wechselseitige Information (MI) über einen Nächster-Nachbar-Algorithmus basierend auf/von den jeweiligen Größen- und Phasenspektren des rauschbehafteten Eingangssignals und des verzögerten rauschbehafteten Eingangssignals bestimmt wird.

**11.** Computerimplementiertes Verfahren nach einem der vorstehenden Ansprüche, *dadurch gekennzeichnet, dass* die wechselseitige Information (MI) über eine histogrammbasierte Schätzung basierend auf den jeweiligen Größen- und Phasenspektren des rauschbehafteten Eingangssignals und des verzögerten rauschbehafteten Eingangssignals bestimmt wird.

**12.** Computerimplementiertes Verfahren nach einem der vorstehenden Ansprüche, *dadurch gekennzeichnet, dass* die wechselseitige Information (MI) über einen parameterbasierten Schätzer basierend auf den jeweiligen Größen- und Phasenspektren des rauschbehafteten Eingangssignals und des verzögerten rauschbehafteten Eingangssignals unter Verwendung eines Gauß'schen Mischungsmodells (GMM) und eines Maximalwahrscheinlichkeitsschätzers oder eines variationalen Bayes'schen Algorithmus zum Lernen der Modellparameter bestimmt wird.

**13.** Computerimplementiertes Verfahren nach einem der vorstehenden Ansprüche, *dadurch gekennzeichnet, dass* die wechselseitige Information (MI) für den Logarithmus der jeweiligen Amplituden und für die jeweiligen Phasen der komplexen Spektralkomponenten des rauschbehafteten Eingangssignals und des mindestens einen verzögerten rauschbehafteten Eingangssignals abgeleitet wird, wobei beide Beiträge gewichtet und addiert werden, und die Gewichtungsfaktoren für gewichtete Addition frequenzabhängig sind.

**14.** Computerimplementiertes Verfahren nach einem der vorstehenden Ansprüche, *dadurch gekennzeichnet, dass* der adaptive Filter als Filter mit finiter Impulsantwort (FIR) oder Filter mit infiniter Impulsantwort (IIR) implementiert ist.

**15.** Computerimplementiertes Verfahren nach einem der Ansprüche 1 bis 13, *dadurch gekennzeichnet, dass* der adaptive Filter als mindestens einer der folgenden Filter implementiert ist: Least Mean Squares- (LMS) Filter, Normalized Least Mean Squares-(NLMS) Filter, Recursive Least Squares- (RLS) Filter.

**16.** Computerimplementiertes Verfahren nach einem der vorstehenden Ansprüche, *dadurch gekennzeichnet, dass* der adaptive Filter mehr als ein Eingangs- und/oder Ausgangssignal empfängt/ausgibt.

**17.** Computerimplementiertes Verfahren nach einem der vorstehenden Ansprüche, *dadurch gekennzeichnet, dass* das Zeitdomänen-Eingangssignal in mehrere Blöcke getrennt ist, wobei die frequenzabhängige Schrittgröße nur einmal für jeden Block berechnet wird.

**18.** Computerimplementiertes Verfahren nach einem der vorstehenden Ansprüche, *dadurch gekennzeichnet, dass* die wechselseitige Information und/oder die berechnete Schrittgröße Änderung unter Einsatz eines Medianfilters unterliegen.

**19.** Computerimplementiertes Verfahren nach einem der vorstehenden Ansprüche, *gekennzeichnet durch* das Entfernen eines Versatzes oder eines Trends aus der wechselseitigen Information (MI) vor Ableiten der Schrittgröße.

**Revendications**

**1.** Procédé mis en oeuvre par ordinateur pour séparer des composantes aléatoires de composantes périodiques d'un signal d'entrée bruité donné x(n) en utilisant un filtre amplificateur de ligne adaptatif (ALE) mis en oeuvre dans le domaine fréquentiel à court terme, comprenant les étapes suivantes :

a. la transformation du signal d'entrée bruité x(n) dans le domaine fréquentiel à court terme pour produire une succession de spectres de phase et d'amplitude à court terme ;
b. le retardement de la succession de spectres de phase et d'amplitude à court terme du signal d'entrée bruité x(n) séparément pour réduire la dépendance statistique de composantes aléatoires par rapport à la succession de spectres de phase et d'amplitude du signal d'entrée bruité x(n) tout en laissant corrélées les composantes de bruit périodiques du signal d'entrée x(n) ;
c. le calcul de mesures d'informations mutuelles dépendantes de la fréquence ($I^A(k)$, $I^P(k)$) pour quantifier la dépendance entre les amplitudes du signal d'entrée bruité et les amplitudes du signal d'entrée bruité retardé, et la dépendance entre les phases du signal d'entrée bruité et les phases du signal d'entrée bruité retardé ;
d. l'obtention d'une taille de pas dépendante de la fréquence ($\mu(k)$) en utilisant les mesures d'informations mutuelles ;
e. la commande d'un filtre adaptatif de l'amplificateur de ligne adaptatif (ALE) dans le domaine fréquentiel en utilisant un ensemble de poids adaptatifs (w(k,m)) qui sont réglés en utilisant la taille de pas dépendante de la fréquence .

**2.** Procédé mis en oeuvre par ordinateur selon la revendication 1, *caractérisé en ce que* la transformation du signal d'entrée bruité dans le domaine fréquentiel à court terme est effectuée par un banc de filtres.

**3.** Procédé mis en oeuvre par ordinateur selon la revendication 1, *caractérisé en ce que* la transformation du signal d'entrée bruité dans le domaine fréquentiel à court terme est effectuée par une transformation de Fourier discrète (DFT).

**4.** Procédé mis en oeuvre par ordinateur selon la revendication 1, *caractérisé en ce que* la transformation du signal d'entrée bruité dans le domaine fréquentiel est effectuée par une transformation orthogonale.

**5.** Procédé mis en oeuvre par ordinateur selon l'une des revendications précédentes, *caractérisé en ce que* le calcul des informations mutuelles (MI) est basé sur des composantes complexes ou une fonction desdites composantes complexes du signal d'entrée bruité transformé et du signal d'entrée bruité transformé retardé.

**6.** Procédé mis en oeuvre par ordinateur selon l'une des revendications précédentes, *caractérisé en ce que,* dans une première étape, les informations mutuelles (MI) sont déterminées séparément sur la base de la partie réelle et de la partie imaginaire de la composante complexe du signal d'entrée transformé et du signal d'entrée bruité transformé retardé et en combinant lesdits résultats calculés séparément à une information mutuelle totale en utilisant des opérateurs mathématiques sélectionnés à partir du groupe comprenant : l'addition, la multiplication, le calcul de la moyenne, le calcul de la moyenne géométrique, le calcul d'une fonction exponentielle, le calcul d'une fonction logarithmique, le calcul de la médiane, le calcul du maximum et le calcul du minimum.

7. Procédé mis en oeuvre par ordinateur selon l'une des revendications précédentes, *caractérisé en ce que* les informations mutuelles (MI) sont déterminées par une fonction de l'amplitude et par une fonction de la phase et en combinant lesdits résultats calculés séparément à une information mutuelle totale en utilisant des opérateurs mathématiques sélectionnés à partir du groupe comprenant : l'addition, la multiplication, le calcul de la moyenne, le calcul de la moyenne géométrique, le calcul d'une fonction exponentielle, le calcul d'une fonction logarithmique, le calcul de la médiane, le calcul du maximum et le calcul du minimum.

8. Procédé mis en oeuvre par ordinateur selon l'une des revendications précédentes, *caractérisé en ce que* les informations mutuelles (MI) sont calculées séparément sur le logarithme des amplitudes et sur les phases des composantes spectrales complexes du signal d'entrée bruité et en combinant lesdits résultats calculés séparément à une information mutuelle totale en utilisant des opérateurs mathématiques sélectionnés à partir du groupe comprenant : l'addition, la multiplication, le calcul de la moyenne, le calcul de la moyenne géométrique, le calcul d'une fonction exponentielle, le calcul d'une fonction logarithmique, le calcul de la médiane, le calcul du maximum et le calcul du minimum.

9. Procédé mis en oeuvre par ordinateur selon l'une des revendications précédentes, *caractérisé en ce que* les informations mutuelles (MI) sont déterminées sur la base des spectres de phase et d'amplitude respectifs du signal d'entrée bruité et du signal d'entrée bruité retardé et le calcul des informations mutuelles est basé sur le coefficient de corrélation et des opérateurs mathématiques sélectionnés à partir du groupe comprenant : l'addition d'une valeur constante, la multiplication par une valeur constante, le calcul d'une fonction exponentielle, le calcul d'une fonction logarithmique et le calcul d'une fonction trigonométrique.

10. Procédé mis en oeuvre par ordinateur selon l'une des revendications précédentes, *caractérisé en ce que* les informations mutuelles (MI) sont déterminées par un algorithme du voisin le plus proche sur de la base des spectres de phase et d'amplitude respectifs du signal d'entrée bruité et du signal d'entrée bruité retardé.

11. Procédé mis en oeuvre par ordinateur selon l'une des revendications précédentes, *caractérisé en ce que* les informations mutuelles (MI) sont déterminées par une estimation à base d'histogramme sur la base des spectres de phase et d'amplitude respectifs du signal d'entrée bruité et du signal d'entrée bruité retardé.

12. Procédé mis en oeuvre par ordinateur selon l'une des revendications précédentes, *caractérisé en ce que* les informations mutuelles (MI) sont déterminées par un estimateur à base de paramètres sur la base des spectres de phase et d'amplitude respectifs du signal d'entrée bruité et du signal d'entrée bruité retardé en utilisant un modèle de mélange gaussien, (GMM) et un estimateur du maximum de vraisemblance ou un algorithme bayésien variationnel pour l'apprentissage des paramètres de modèle.

13. Procédé mis en oeuvre par ordinateur selon l'une des revendications précédentes, *caractérisé en ce que* les informations mutuelles (MI) sont dérivées pour le logarithme des amplitudes respectives et des phases respectives des composantes spectrales complexes du signal d'entrée bruité et de l'au moins un signal d'entrée bruité retardé, dans lequel les deux contributions sont pondérées et additionnées et les facteurs de pondération pour l'addition pondérée sont dépendants de la fréquence.

14. Procédé mis en oeuvre par ordinateur selon l'une des revendications précédentes, *caractérisé en ce que* le filtre adaptatif est mis en oeuvre comme un filtre à réponse impulsionnelle finie (FIR) ou un filtre à réponse impulsionnelle infinie (IIR).

15. Procédé mis en oeuvre par ordinateur selon l'une des revendications 1 à 13, *caractérisé en ce que* le filtre adaptatif est mis en oeuvre comme au moins un des filtres suivants : un filtre des moindres carrés moyens (LMS), un filtre des moindres carrés moyens normalisés (NLMS), un filtre des moindres carrés récursifs (RLS).

16. Procédé mis en oeuvre par ordinateur selon l'une des revendications précédentes, *caractérisé en ce que* le filtre adaptatif reçoit/transmet plus d'un signal d'entrée et/ou de sortie.

17. Procédé mis en oeuvre par ordinateur selon l'une des revendications précédentes, *caractérisé en ce que* le signal d'entrée de domaine temporel est séparé en plusieurs blocs, dans lequel la taille de pas dépendante de la fréquence est calculée seulement une fois pour chaque bloc.

18. Procédé mis en oeuvre par ordinateur selon l'une des revendications précédentes, *caractérisé en ce que* lesdites informations mutuelles et/ou ladite taille de pas calculée sont soumises à une modification en utilisant un filtre médian.

19. Procédé mis en oeuvre par ordinateur selon l'une des revendications précédentes, *caractérisé par* l'élimination d'un décalage ou une tendance par rapport aux informations mutuelles (MI) avant l'obtention de la taille de pas.

Fig. 1

# Fig. 2a

# Fig. 2b

# Fig. 2c

# Fig. 2d

Fig. 3a

Fig. 3b

Fig. 4

## Fig. 5a

**Spectrogram noisy speech (5dB SNR)**

## Fig. 5b

**log-magnitude spectrum - clean speech**

## Fig. 5c

**phase spectrum - clean speech**

## Fig. 5d

**log-magnitude spectrum - noisy speech vacuum cleaner**

## Fig. 5e

**phase spectrum - noisy speech vacuum cleaner**

Fig. 6a

phase spectrum - noisy speech WGN

Fig. 6b

phase spectrum - noisy speech babble

Fig. 6c

phase spectrum - noisy speech vehicle engine

Fig. 6d

phase spectrum - noisy speech traffic

Fig 6e

phase spectrum - noisy speech kitchen appliance

## Fig. 7a

phase spectrum - after normalization

## Fig. 7b

log-magnitude and phase spectra - after normalization

## Fig. 7c

phase spectrum - after median filtering

## Fig. 7d

log-magnitude and phase spectra - after median filtering

## Fig. 7e

step-size $\mu(k)$

Fig. 8

## Fig. 9a

noisy speech (vehicle engine, 5dB SNR)

## Fig. 9b

enhanced speech

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- **J. BEIRLANT ; E. J. DUDEWICZ ; L. GYÖRFI ; E. C. VAN DER MEULEN.** Nonparametric entropy estimation: An overview. *Int. J. Math. Stat. Sci.,* 1997, vol. 6, 17-39
- **C. M. BISHOP.** Pattern recognition and machine learning. Springer, 2006
- **J. F. CARDOSO.** Dependence, correlation and Gaussianity in independent component analysis. *The Journal of Machine Learning Research,* 2003, vol. 4, 1177-1203
- **T. M. COVER ; J. A. THOMAS.** Elements of information theory. Wiley, 2006
- **D. EVANS.** A computationally efficient estimator for mutual information. *Proc. R. Soc. A, Mathematical, Physical and Engineering Sciences,* 2008, vol. 464, 1203-1215
- **B. GOEBEL ; R. ESSIAMBRE ; G. KRAMER P ; J. WINZER ; N. HANIK.** Calculation of mutual information for partially coherent Gaussian channels with applications to fiber optics. *IEEE Transactions on Information Theory,* September 2011, vol. 57 (9), 5720-5736
- **P. HALL ; S. C. MORTON.** On the estimation of the entropy. *Ann. Inst. Statist. Math.,* 1993, vol. 45, 69-88
- **S. HAYKIN.** Adaptive filter theory. Prentice Hall, 2002
- **R. C. HENDRIKS ; R. HEUSDENS ; J. JENSEN.** An MMSE estimator for speech enhancement under a combined stochastic-deterministic speech model. *IEEE Transactions on Audio, Speech, and Language Processing,* February 2007, 406-415
- **A. KRASKOV ; H. STÖGBAUER ; P. GRASSBERGER.** Estimating mutual information. *Phys. Rev.,* 2004, vol. E 69 (6), 1-16
- **S.M. KUO ; D.R. MORGAN.** *Active noise control systems: algorithms and DSP implementations,* 2006
- **P. LOIZOU.** Speech Enhancement: Theory and Practice. CRC, 2007
- **I. NAKANISHI ; Y. ITOH ; Y. FUKUI.** Noise reduction system based on frequency domain adaptive filter using modified DFT pair. *The 2001 IEEE International Symposium on Circuits and Systems,* May 2001, vol. 2, 737-740
- **I. NAKANISHI ; H. NAMBA ; S. LI.** Speech enhancement based on frequency domain ALE with adaptive de-correlation parameters. *International Journal of Computer Theory and Engineering,* 2013, vol. 5 (2), 292-297
- Estimation with minimum mean square error. **A. V. OPPENHEIM ; G. C. VERGHESE.** Introduction to Communication, Control, and Signal Processing: Lecture Notes. MIT, 2010
- **R. M. RAMLI ; A. O. ABID NOOR ; S. A. SAMAD.** A review of adaptive line enhancers for noise cancellation. *Australian Journal of Basic and Applied Sciences,* 2012, vol. 6 (6), 337-352
- **N. SASAOKA ; K. SHIMIDA ; S. SONOBE ; Y. ITOH ; K. FUJII.** Speech enhancement based on adaptive filter with variable step size for wideband and periodic noise. *Proceedings of IEEE International Midwest Symposium on Circuits and Systems,* 2009, 648-652
- **D. W. SCOTT.** *Multivariate density estimation: theory, practice, and visualization,* 1992
- **J.J. SHYNK.** Frequency-domain and multirate adaptive filtering. *IEEE Signal Processing Magazine,* January 1992, vol. 9 (1), 14-37
- **C. H. TAAL ; R. C. HENDRIKS ; R. HEUSDENS ; J. JENSEN.** An algorithm for intelligibility prediction of time-frequency weighted noisy speech. *IEEE Transactions on Audio, Speech, and Language Processing,* September 2011, vol. 19 (7), 2125-2136
- **J. TAGHIA ; R. MARTIN.** A negentropy based adaptive line enhancer for single-channel noise reduction at low SNR conditions. *IEEE International Conference on Acoustics, Speech, and Signal Processing (ICASSP),* May 2014, 7073-7077
- **J. TAGHIA ; R. MARTIN.** Objective intelligibility measures based on mutual information for speech subjected to speech enhancement processing. *IEEE Transactions on Audio, Speech, and Language Processing,* January 2014, vol. 22 (1), 6-16
- **A. VARGA ; H. J. M. STEENEKEN.** Assessment for automatic speech recognition: II. Noisex-92: A database and an experiment to study the effect of additive noise on speech recognition systems. *Speech Commun.,* 1993, vol. 12 (3), 247-251
- **P. VARY ; R. MARTIN.** Digital Speech Transmission - Enhancement, Coding and Error Concealment. John Wiley, 2006

- **B. WIDROW ; J.R. GLOVER ; J.M. MCCOOL ; J. KAUNITZ ; C.S. WILLIAMS ; R.H. HEARN ; J.R. ZEIDLER ; D. EUGENE, JR. ; R.C. GOODLIN.** Adaptive noise cancelling: Principles and applications. *Proceedings of the IEEE,* December 1975, vol. 63 (12), 1692-1716

- **Q. XIE ; Z. WANG ; Z. YANG.** Polar decomposition of mutual information over complex-valued channels. *Computer Science - Information Theory,* March 2013